# EUROPEAN PATENT APPLICATION

(11) **EP 1 624 313 A1**
(43) Date of publication of application: **08.02.2006**
(21) Application number: 05016668.5
(22) Date of filing: 01.08.2005
(51) Int. Cl.: G01R 15/18, G01R 15/20

(54) **Method and apparatus for measuring electric currents in conductors**

(30) Priority: 02.08.2004 IT MI20041589
(71) Applicant: HERHOLDT CONTROLS S.R.L., 20132 Milano (IT)
(72) Inventor: Cavagnolo, Gianpaolo, 20090 Vimodrone (MI) (IT); Bottauscio, Oriano, 10126 Torino (IT); Crotti, Gabriella, 10129 Torino (IT); Zucca, Mauro, 10152 Torino (IT); Chiampi, Mario, 10144 Torino (IT)
(74) Representative: Modiano, Micaela Nadia

(57) **Abstract**

A device for obtaining the modulus and phase value of the current flowing through one or more conductors, which comprises a plurality of transducers adapted to measure the magnetic field generated by the one or more conductors when the current to be measured flows through them, the plurality of transducers being arranged around the conductors through which the current flows.

## Description

The present invention relates to a device and a method for measuring the modulus and phase value of the current flowing through at least one conductor or multiple conductors. More particularly, the invention relates to a device and a method capable of obtaining the modulus and phase value of the current flowing through a set of conductors, which is particularly suitable for DC, DC/AC or AC ammeter in single-phase and multiphase systems with *n* conductors, or in DC, DC/AC or AC wattmeters in single-phase and multiphase systems with n conductors, or in energy meters or in current threshold sensing circuits for protecting electrical systems against overcurrents or circuits for detecting leakage currents.

As is known, measuring in terms of modulus and phase the current that flows through a set of conductors is particularly important as regards the cases described above, and measurement devices which are external to the conductors whose current is to be measured in terms of modulus and phase are used in particular for this purpose.

However, the solutions of the background art are affected by drawbacks caused by their dimensions, since said devices cannot be inserted in units such as motorized breakers, terminals and electrical panels of the compact type, and are also affected by the fact that they are not suitable for use in hostile environments.

The aim of the present invention is to provide a device and a method for obtaining the modulus and phase value of the current flowing through at least one conductor, in which the device is extremely compact, so that it can be inserted in units such as motorized breakers, terminals and electrical panels of the compact type.

Within this aim, an object of the present invention is to provide a device and a method capable of obtaining the modulus and phase value of the current that flows through at least one conductor, which allow to provide measurement systems that are mechanically extremely strong and suitable for hostile environments.

Another object of the present invention is to provide a device and a method for obtaining the modulus and phase value of the current flowing through a set of conductors in which the conductors can assume any shape and length.

Another object of the present invention is to provide a device and a method that are highly reliable, relatively simple to provide and at competitive costs.

This aim and these and other objects, which will become better apparent hereinafter, are achieved by a device for obtaining the modulus and phase value of the current flowing through one or more conductors, characterized in that it comprises multiple transducers adapted to measure the magnetic field generated by said one or more conductors when the current to be measured flows through said one or more conductors, said plurality of transducers being arranged around said conductors through which the current flows.

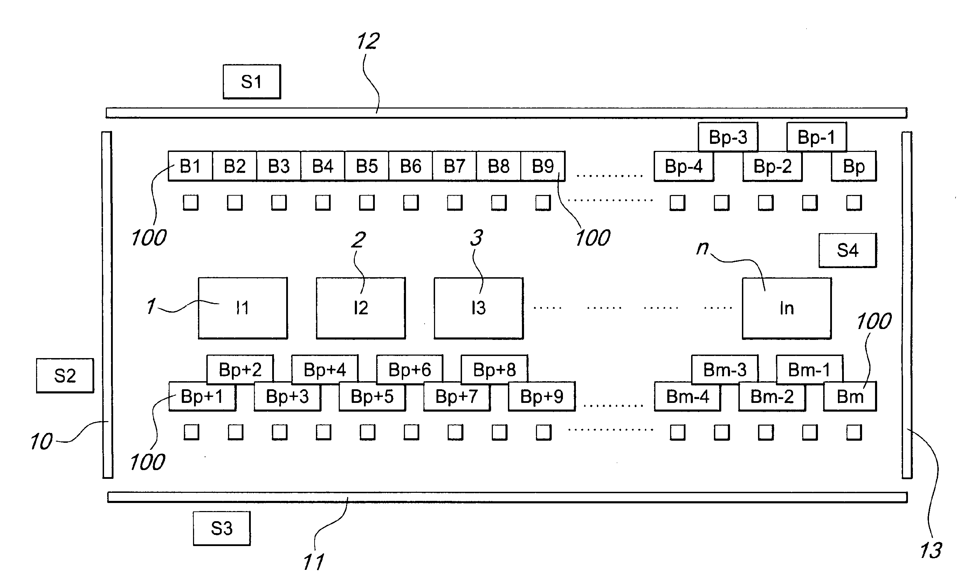

Further characteristics and advantages of the invention will become better apparent from the description of preferred but not exclusive embodiments of the device according to the present invention, illustrated by way of non-limiting example in the accompanying drawing, wherein the sole figure is a schematic view of an example of embodiment of the device according to the present invention.

With reference to the figure, the device according to the present invention comprises, in order to measure the modulus and phase value of the current flowing through a plurality of conductors 1, 2, 3, ...n, a plurality of transducers, their number being at least greater than the number of conductors through which the current flows.

In the figure, the transducers are designated by the reference numerals 100 and are provided in a number comprised between n, i.e., the maximum number of conductors through which current flows, and infinity.

Conveniently, the transducers are transducers suitable to detect the magnetic field generated by the conductors 1, ...n, when the current to be measured flows through them.

The magnetic field can be measured in various points and it is possible for example to list the following types of transducer:
- Hall-effect transducers;
- magnetoresistive transducers;
- transducers using Rogowsky coils;
- use of transformers with a core affected by the magnetic field to be measured.

It is convenient for the size of the transducer to be small with respect to the distance from the center of gravity of the cross-section of the conductor through which the current to be measured flows.

The transducers or sensor elements can be arranged in all of the three-dimensional space that surrounds the conductors 1, ...*n*.

An appropriate ferromagnetic material can be inserted around the sensors 100 both to alter the shape of the magnetic field and to provide shielding against external fields. The effect of external fields can be made uniform for each pair of sensors 100 subjected to opposite values of the magnetic field generated by the current Ix (where x is comprised between zero and n), using appropriate shields made of ferromagnetic material which are arranged around the set of sensors 100, either by providing a closed circuit or by leaving appropriate openings.

By way of example, the figure illustrates the cross-sections of four shields 10, 11, 12 and 13 made of ferromagnetic material, but the number of shields can be any and the shapes and arrangements can be different.

In particular, shields can also be placed between the conductors 1, 2, ... n.

As mentioned, the number of transducers or sensors 100 must exceed the number of conductors 1, ...*n* and preferably should be approximately twice the number of the conductors. The larger the number of sensors or transducers 100, the higher the performance in terms of precision and insensitivity to noise.

The measurement of the magnetic field generated by the system of conductors can be made by using the Biot-Savart formula, which also involves the currents (which are the unknowns in the present case).

Therefore, starting from knowledge of the magnetic field, which is measured, it is possible to determine the currents that generate said magnetic field.

The noise generated by an external magnetic field can be reduced by resorting to the shields described earlier and by making the external magnetic field sufficiently uniform in the region of the sensors.

In practice it has been found that the device and the method according to the invention fully achieve the intended aim and objects, since they allow to obtain a measurement of the modulus and phase value of the current that flows through conductors by utilizing the measurement of the magnetic field generated by said conductors when the current to be measured flows through them.

The device and method thus conceived are susceptible of numerous modifications and variations, all of which are within the scope of the appended claims; all the details may furthermore be replaced with other technically equivalent elements.

In practice, the materials used, as well as the contingent shapes and dimensions, may be any according to the requirements and the state of the art.

The disclosures in Italian Patent Application no. MI2004A001589, from which this application claims priority, are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A device for obtaining the modulus and phase value of the current flowing through one or more conductors, **characterized in that** it comprises a plurality of transducers adapted to measure the magnetic field generated by said one or more conductors when the current to be measured flows through said one or more conductors, said plurality of transducers being arranged around said conductors through which the current flows.

2. The device according to claim 1, **characterized in that** said transducers are arranged in all of the three-dimensional space that surrounds said conductors.

3. The device according to claim 1, **characterized in that** it provides shields made of ferromagnetic material, which are arranged around said conductors in order to provide a closed surface or a surface with openings.

4. The device according to one or more of the preceding claims, **characterized in that** said transducers are Hall-effect transducers.

5. The device according to one or more of the preceding claims, **characterized in that** said transducers are magnetoresistive-effect transducers.

6. The device according to one or more of the preceding claims, **characterized in that** said transducers are Rogowsky coils.

7. The device according to one or more of the preceding claims, **characterized in that** said transducers are transformers in which the core is affected by the magnetic field to be measured in order to obtain said current.

8. The device according to one or more of the preceding claims, **characterized in that** the size of each one of said transducers is small with respect to the distance from the center of gravity of the cross-section of the conductor through which the current flows.

9. The device according to one or more of the preceding claims, **characterized in that** it comprises one or more of the described and/or illustrated characteristics.

10. A method for obtaining the modulus and phase value of the current flowing through one or more conductors, **characterized in that** it comprises the steps that consist in:
- arranging a plurality of transducers suitable to measure the magnetic field generated by said one or more conductors through which the current to be measured flows, the number of said transducers being greater than the number of said conductors;
- measuring said magnetic field;
- determining, starting from the measurement of said magnetic field, the measurement of the current that has generated said magnetic field.

11. The method according to claim 1, **characterized in that** said transducers are arranged around said conductors.

12. The method according to claim 10, **characterized in that** shields made of ferromagnetic material are arranged around said conductors through which the current to be measured flows.

13. The method according to claim 11, **characterized in that** electromagnetic shields are arranged between said conductors through which the current to be measured flows.
